# EUROPEAN PATENT SPECIFICATION

(11) **EP 0 732 735 B1**
(45) Date of publication and mention of the grant of the patent: **14.12.2005**
(21) Application number: 96400545.8
(22) Date of filing: 15.03.1996
(51) Int. Cl.: H01L 21/48, C04B 41/51, H01G 4/30

(54) **Monolithic ceramic electronic device and method of manufacturing same**
Monolithisches Keramikbauelement und seine Herstellung
Dispositif céramique et méthode de fabrication associée

(30) Priority: 16.03.1995 JP 5730395; 04.04.1995 JP 7912095
(43) Date of publication of application: 18.09.1996
(73) Proprietor: MURATA MANUFACTURING CO., LTD., Nagaokakyo-shi Kyoto-fu 226 (JP)
(72) Inventor: Kawakami, Hiroyuki, c/o Murata Manufac. Co., Ltd., Nagaokakyo-shi, Kyoto-fu (JP); Kohno, Yoshiaki, c/o Murata Manufac. Co., Ltd., Nagaokakyo-shi, Kyoto-fu (JP); Kubodera, Noriyuki, c/o Murata Manufac. Co., Ltd., Nagaokakyo-shi, Kyoto-fu (JP)
(74) Representative: Joly, Jean-Jacques

(56) References cited:
- EP-A- 0 474 176
- EP-A- 0 485 176
- US-A- 4 221 047
- US-A- 4 879 156
- US-A- 4 929 295
- US-A- 5 046 236
- US-A- 5 101 319
- PATENT ABSTRACTS OF JAPAN vol. 095, no. 004, 31 May 1995 & JP 07 029771 A (MURATA MFG CO LTD), 31 January 1995,
- PATENT ABSTRACTS OF JAPAN vol. 009, no. 134 (C-285), 8 June 1985 & JP 60 021393 A (SUMITOMO DENKI KOGYO KK), 2 February 1985,

## Description

### BACKGROUND OF THE INVENTION

### Field of the Invention

The present invention relates to an electronic part and a method of manufacturing same, and more particularly to a monolithic ceramic electronic device and a method of manufacturing same.

The present invention can be adapted to a variety of electronic devices, e.g. a monolithic capacitor, a monolithic piezoelectric device or a multilayered ceramic substrate, and a method of manufacturing such devices.

### Related Background Art

A method of integrally firing metal elements and ceramic elements has been employed for manufacturing a monolithic ceramic electronic device, such as a monolithic capacitor, having internal electrodes. Firstly, a pattern made of conductive paste is printed on a ceramic green sheet to form internal electrodes. Then, a plurality of the ceramic green sheets each having the internal electrodes are laminated, and then an appropriate number of ceramic green sheets having no internal electrode are laminated on the both sides of the stack of green sheets to form a monolithic ceramic structure. Alternatively, a predetermined pattern of ceramic paste and conductive paste may be sequentially printed to form a monolithic ceramic structure.

Then, the monolithic ceramic structure is pressed in a direction of its thickness so that the ceramic layers are brought into tight contact with each other. Further, the monolithic ceramic structure is fired to obtain a sintered structure. Appropriate external electrodes are formed on the outer surface of the sintered structure to produce a monolithic ceramic electronic part.

In recent years electronic parts are required to reduce the sizes thereof and, as well, monolithic ceramic electronic devices must reduce the sizes and the thicknesses thereof. When the monolithic ceramic electronic device is intended to be reduced in size and thickness, the ceramic layers, each of which is held between the internal electrodes, are required to be thinned. Accordingly, thinner green sheets are required when the monolithic ceramic structure is manufactured.

However, it is difficult to treat excessively thin ceramic green sheets. Moreover, the thickness of portions each including the internal electrodes, which overlap one another, is larger than that of portions each including no internal electrode in a monolithic ceramic structure. As a result, stepped portions have been inevitably formed between the portions.

In particular, since the stepped portions are formed when the monolithic ceramic structure is pressed in the direction of its thickness prior to firing process, the pressure is mainly applied onto the portions including the internal electrodes which overlap one another. Accordingly, the pressure is insufficient in the other portions. As a result, there is a possibility that a layer separating phenomenon called delamination occurs. Also, there is a possibility that solvent in the ceramic green sheet causes the internal electrodes to swell. Then, the internal electrodes can not accurately be formed into desired shapes.

Therefore, it has been extremely difficult to reduce the thickness of a ceramic green sheet to about 6 µm or thinner.

Such problems may arise in making a monolithic ceramic structure in which ceramic paste and conductive paste are alternately laminated.

To overcome the problems, a method has been suggested in which portions of a metal film, formed by a thin film forming method, are used as the internal electrodes, the method being exemplified by the following first to third prior art methods.

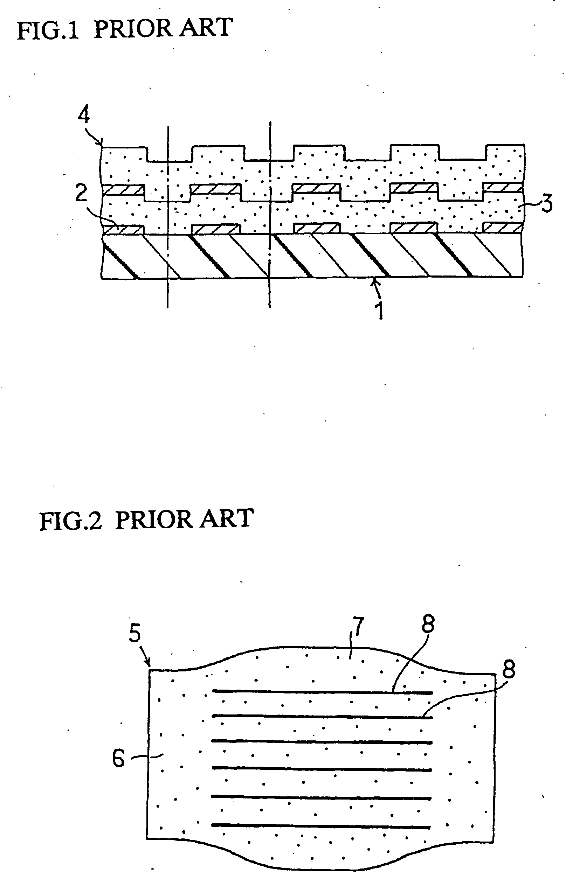

The first method has the step of forming a metal film on the overall surface of a supporting member by using a thin film forming method, such as a sputtering method. Then, a resist layer having openings corresponding to the shapes of the electrodes is formed on the metal film, and then the metal film is patterned by photolithography. Thus, a metal film 2 is formed as shown in Fig. 1. Then, a ceramic green sheet 3 is formed on the metal film 2. By repeating the process for forming the metal film 2 and that for forming the ceramic green sheet 3, a monolithic structure 4 is formed.

In the second method which is disclosed in JP-A-64-42809, a ceramic green sheet is formed on a first film made of synthetic resin; and a metal film is formed on a second supporting film by a thin film forming method. Then, the metal film supported by the second supporting film is transferred to the ceramic green sheet on the first supporting film to produce a green sheet having a metal film thereon. A monolithic ceramic structure is obtained by laminating a plurality of such green sheets.

The third method has the step of forming a metal film on the overall surface of a supporting film by a thin film forming method. Then, the metal film is patterned by a photolithography method. Next, a ceramic green sheet is formed on the supporting film having the patterned metal film so that a green sheet having the metal film is obtained. Then, the green sheet supported by the supporting film is laminated on a laminating stage by transferring with heat so that a monolithic ceramic structure is obtained.

The first to third methods, in each of which portions of the metal film formed by the thin film forming method are used as the internal electrodes, are able to further thin the internal electrodes as compared with the method of forming the internal electrodes by using conductive paste.

However, an attempt to further thin each layer encounters an increase in the number of the laminated layers, thus causing the internal electrodes to be thickened with respect to the thickness of the ceramic layer held between the internal electrodes. As a result, the first method involves the difference in the thickness between a portion 6, in which only the ceramic green sheets are laminated, and a portion 7, in which internal electrodes 8 overlap one another, as shown in Fig. 2. Therefore, when the laminated structure is pressed in the direction of its thickness, the pressure is easily applied to only the portion in which the internal electrodes 8 overlap one another. Thus, the strength of adhesion between the ceramic layers may reduce in the region, in which the internal electrodes do not overlap. As a result, delamination may easily take place when the laminated structure is sintered.

Moreover, the first method requires further processes after the metal film has been formed on the supporting member, such as a step for forming patterns of a resist layer, a step for etching the pattern and a step for stripping the resist layer off.

The second method also encounters a problem of thickening of the portion in which the internal electrodes overlap one another, as compared with the region having no internal electrodes. Therefor, the second method also may suffer from the delamination problem. Further, in the case where the ceramic green sheet is extremely thinned, it would be difficult to treat such a green sheet. Moreover, it would be difficult to attain high accuracy of position of the metal film on a green sheet because a transferring process is involved.

And, in the transferring process, the portion having no metal film involves the ceramic green sheet being brought into contact with the second supporting film. The second supporting film must be stripped from the green sheet having the metal film after the transferring process. Therefore, both of the metal film and the ceramic green sheet must be easily stripped from the second supporting film. However, the requirement can not easily be satisfied. Thus, there is a possibility that a portion of a ceramic green sheet is destroyed when stripping the second supporting film.

Since the third method has the steps of forming the metal film by the thin film forming method and then performing the patterning process by the photolithography method, the manufacturing process tends to become complicated. Moreover, the structure in which the metal film and the ceramic green sheet are in contact with the supporting film requires both of the metal film and the ceramic green sheet to be easily stripped from the supporting film when the transfer from the supporting film is performed. However, the requirement cannot easily be satisfied.

EP-A-0 485 176 describes a two-layer metal thin film structure which can be used to provide internal electrodes in a monolithic ceramic device. This two-layer structure is formed on a support member by thin film forming methods. The layer in contact with the support member is designed for ease of peeling whereas the other layer is designed with a view to desired electrode characteristics. The two layers have the same shape and extent.

### SUMMARY OF THE INVENTION

Accordingly, an object of the present invention is to provide a method of manufacturing a monolithic ceramic electronic device capable of preventing occurrence of the difference in the thickness between a region, in which internal electrodes are formed, and a region, in which the internal electrodes are not formed, in a monolithic ceramic structure and therefore capable of effectively preventing delamination so as to be capable of simply and stably manufacturing a monolithic ceramic electronic device as compared with a conventional method of manufacturing the monolithic ceramic electronic part including a step of forming the internal electrodes by a thin film forming method.

To achieve the object, according to one aspect of the present invention, there is provided a method of manufacturing a monolithic ceramic electronic device, comprising the steps of: forming a first metal film on a first supporting member by a thin film forming method; forming a multilayered metal film by forming a second metal film on said first metal film by a thin film forming method; wherein there are portions of said first metal film that are not overlain by said second metal film; said first metal film has a first thickness, and said second metal film has a second thickness, greater than said first thickness, the first and second thicknesses being selected such that common firing conditions can form a portion of said first metal film which is not overlaid by said second metal film in said monolithic ceramic structure into an insulating structure but not so form the second metal film; and the method further comprises the steps of: forming a monolithic ceramic structure incorporating said multilayered metal film and at least one ceramic green sheet; and forming said portion of said first metal film which is not overlaid by said second metal film in said monolithic ceramic structure into an insulating structure by firing said monolithic ceramic structure.

According to another aspect of the present invention, the step of forming the monolithic ceramic structure has the steps of forming a ceramic green sheet on a second supporting member; and separating the monolithic ceramic structure from the first supporting member while separating the ceramic green sheet from the second supporting member, and alternately stacking, on a laminating stage, the monolithic ceramic structure and the ceramic green sheet.

According to a further aspect of the present invention, the step of forming the monolithic ceramic structure has the steps of forming a ceramic green sheet on a second supporting member; transferring, onto the ceramic green sheet, the monolithic ceramic structure on the first supporting member to form a green sheet including a metal film; sequentially transferring and stacking a plurality of the green sheets each having the metal film thereby to form the monolithic ceramic structure.

It is preferable that transfer of the metal film be performed by using a roll press in the step of forming the green sheet having the metal film by the transferring method so as to enable a thin metal film to be easily and smoothly transferred to the ceramic green sheet.

In the present invention, the first metal film is thinner than the second metal film. The thickness is determined to have a value with which the first metal film can be formed into an insulating structure during firing. The process for forming the first metal film into the insulating structure can be realized due to diffusion of the metal composing the metal film into the surrounding ceramics, the metal being diffused in the form of oxide ions. Although the thickness with which the first metal film is formed into the insulating structure cannot be determined definitely because the thickness becomes different depending upon the material composing the first metal film and firing conditions including the firing temperature, it is preferable that the thickness be 0.1 µm or thinner. As a result, the first metal film can reliably be formed into the insulating structure.

The resist layer is mainly composed of resist resin which disappears when fired. Since the resist layer disappears when the firing process is performed, a process for stripping the resist layer is not required in the present invention. Moreover, surrounding ceramics are, in the firing process, moved to the portion in which the resist layer has disappeared. Therefore, a problem of generation of voids can be prevented.

Preferably inorganic components are added to the resist. The inorganic components are composed of inorganic materials, such as ceramics or glass, which do not disappear after firing. Thus, the inorganic components have a function of preventing reduction of the strength of the portion in which the resist layer has disappeared. In the case where the inorganic components are contained in the resist layer, the surrounding ceramics are smoothly moved to the portion in which the resist resin has disappeared due to firing. As a result, a condition of sintering can be the same as the other ceramic portion. Therefore, the structure, in which the inorganic components are contained in the resist layer, enables a further uniform and dense sintered structure to be obtained.

The materials of the first and second metal films are not limited particularly. According to a still another aspect of the present invention, the first metal film contains Cu and the second metal film contains Ni. The first metal film containing Cu can easily be changed into oxides and the insulating structure after firing. By forming the second metal film with Ni, the cost for forming the internal electrodes can be reduced.

According to a still further aspect of the present invention, the thickness of the first metal film is 100 nm or thinner and the thickness of the second metal film is between 300 nm and 1000 nm. The reason for this is that the first metal film must be structured in such a manner that the portion of the first metal film which is not located below the second metal film is required to be changed into the insulating structure when the ceramics are fired. That is, the thickness of the first metal film is made to be 100 nm so a to cause the metal components composing the first metal film to easily be diffused into the ceramics due to firing in such a manner that the metal components are in the form of oxide ions when diffused. The reason why the thickness of the second metal film is made to be 300 nm or thicker is that oxidation of the second metal film is prevented when the first metal film portion is changed into the insulating structure. That is, the second metal film is a portion to serve as the internal electrodes. Note that the upper limit of the thickness of the second metal film is not limited particularly. However, to use the second metal film as the internal electrodes of a monolithic ceramic electronic device and to achieve the object of the present invention, which is the prevention of generation of a stepped portion, the thickness is usually determined to be 1000 nm or thinner.

According to one aspect of the present invention, the step of forming the part of the first metal film into the insulating structure and firing the ceramics is performed by firing the monolithic ceramic structure under a partial pressure for oxygen at which the first metal film is oxidized but the second metal film is not oxidized. That is, control of the partial pressure for oxygen to this level enables, at the time of firing the ceramics, the first metal film to be oxidized and the first metal film portion which is not located below the second metal film to be formed into the insulating structure, and prevents oxidation of the second metal film. The level of the partial pressure for oxygen can be determined appropriately to adopt different materials and the thicknesses of the first and second metal films and temperature and time for which the firing process is performed.

The step of forming the multilayered metal film can be performed by an appropriate photolithography method. For example, the step of forming the multilayered metal film has the steps of forming, on the first metal film, a resist layer having pattern holes therein; forming, in the pattern holes in the resist layer, second metal films each of which is thicker than that of the first metal film by the thin film forming method; and stripping the resist layer.

Also the step of forming the monolithic ceramic structure including the multilayered metal film can be realized by a conventional transfer method. According to another aspect of the present invention, the step of forming the monolithic ceramic structure has the steps of forming green sheet including metal film by forming a ceramic green sheet on the multilayered metal film; and stacking a plurality of such green sheets. According to another aspect of the present invention, the step of forming the monolithic ceramic structure is realized by a transferring method having the steps of forming a ceramic green sheet on a second supporting member; forming a green sheet including metal film by transferring, to the ceramic green sheet, the multilayered metal film supported by the first supporting member; and forming the monolithic ceramic structure by sequentially transferring a plurality of the green sheets each having metal film. When the transferring method is employed, it is preferable that a roll press be used to transfer the multilayered metal film to the ceramic green sheet.

In the present invention, the first metal film is formed, and then the resist layer is formed. Then, the second metal films are formed within the pattern holes in the resist layer so that a laminated member including metal-layer and resist-layer is formed. Therefore, preliminary operations, such as etching and stripping of the resist layer, are not required. That is, the step of etching the first metal film and the step of stripping the resist can be omitted. Therefore, the time required to process the metal film formed by the thin film forming method can significantly be shortened. Moreover, the incidence of defective parts can be lowered, the incidents being due to the process of washing the etching liquid. Since the resist is not required to have etching resistance, resin for forming the resist may be selected from a variety of materials. Thus, the cost of the material can be reduced.

Moreover, in the step of firing the monolithic ceramic structure including a laminated member having metal layer and resist layer, the resist layer is stripped and the first metal film is changed into the insulating structure at the same time as the ceramics are fired. Therefore, no additional process is required in order to easily and stably obtain a sintered structure for a monolithic ceramic electronic device in which internal electrodes formed by the second metal film are stacked.

The first metal film formed on the overall surface enables the stepped portion between the portion, in which the internal electrodes overlap one another, and the portion, in which the internal electrodes do not overlap, to be reduced. As a result, generation of delamination can be prevented satisfactorily.

In the case where the step of forming the monolithic ceramic structure consists of the step of forming the ceramic green sheet on the second supporting member; and the step of alternately stacking, on the stacking stage, a laminated member having the metal-layer and resist-layer supported on the first supporting member and the ceramic green sheet supported by the second supporting member, a sole member is stripped from each supporting member. That is, the first metal film is stripped from the first supporting member and the green sheet is stripped from the second supporting member. Therefore, the force required to strip the member can easily be controlled.

In the case where the step of forming the monolithic ceramic structure is performed by the transferring method, that is, in the case where the ceramic green sheet is previously formed on the second supporting member, and then a laminated member having metal layers and resist layers is transferred to the ceramic green sheet to form the green sheet integrally having the metal film, only the ceramic green sheet is stripped from the supporting member when the stacking process is performed. Therefore, the stripping facility with respect to the supporting member can easily and reliably be controlled. As a result, by using the transfer method, a further thinner ceramic green sheet and electrode material may be employed to manufacture a monolithic ceramic electronic device. Moreover, delamination can be prevented which occurs due to defective stacking and/or defective pressing.

As a result, according to the present invention, if the thickness of a monolithic ceramic electronic device to be manufactured is intended to be reduced and the number of stacked internal electrode layers of the same is intended to be increased, the incident of defective parts due to delamination can be lowered. Moreover, monolithic ceramic electronic devices can stably be supplied with a simple process.

The method of manufacturing the monolithic ceramic electronic device according to the present invention has the structure such that the first metal film formed on the overall surface enables the stepped portion between the region, in which the internal electrodes overlap one another (the region in which the second metal films overlap one another) and the region, in which the internal electrodes do not overlap, to be reduced. As a result, generation of delamination in the obtained sintered structure can effectively be prevented.

Moreover, the first metal film is formed into the insulating structure during the process for firing the ceramics. Therefore, the first metal film formed to reduce the stepped portion does not act as a conductor. As a result, even if the first metal film is formed, short circuits and the like can be prevented. Moreover, the necessity of partially stripping the first metal film in the following step by etching or the like can be eliminated. Therefore, an additional process for forming a multilayered metal film is not required.

The first metal film is, in the form of oxide ions, diffused in the ceramics. By controlling the composition of the first metal film, the composition of the ceramics can be controlled. Therefore, a monolithic ceramic electronic device exhibiting desired characteristics can be provided.

The multilayered metal film is supported by the supporting member. In this state, only the first metal film is in contact with the supporting member. Therefore, the stripping facility of the multilayered metal film with respect to the supporting member is permitted to be determined in terms of realizing satisfactory stripping facility of the supporting member with respect to the first metal film. Therefore, the stripping facility of the supporting member can easily be determined. As a result, in an example case where the multilayered metal film is transferred to the ceramic green sheet formed on the second supporting member, the multilayered metal film can easily be stripped from the supporting member. Since the second supporting member is in contact with only the ceramic green sheet, the second supporting member is required to be stripped easily and smoothly from the ceramic green sheet. Therefore, the second supporting member is required to have a simple stripping characteristic.

The present invention may be adapted to any of a variety of methods of manufacturing a monolithic ceramic electronic device of a type including internal electrodes, such as, for example, a monolithic capacitor, a ceramic-laminated piezoelectric part and a multilayered ceramic substrate.

Other objects, features and advantages of the invention will be evident from the following detailed description of the preferred embodiments described in conjunction with the attached drawings.

### BRIEF DESCRIPTION OF THE DRAWINGS

Fig. 1 is a cross sectional view showing a conventional method of manufacturing a monolithic capacitor;
Fig. 2 is a cross sectional view showing a monolithic ceramic structure in a conventional monolithic capacitor;
Fig. 3A and 3B are cross sectional views respectively showing a state where a first metal film is formed on a first supporting member according to a first embodiment of the present invention and a state where a resist layer and a second metal film are formed;
Fig. 4 is a cross sectional view showing a state where a ceramic green sheet is formed on a second supporting member;
Fig. 5 is a cross sectional view showing a monolithic structure before it is fired;
Fig. 6 is a horizontal cross sectional view showing a sintered structure obtained by firing a monolithic chip;
Fig. 7 is a schematic cross sectional view showing a monolithic capacitor obtained in the first embodiment;
Fig. 8 is a cross sectional view showing a state where a first metal film is formed on a first supporting member according to a fourth embodiment;
Fig. 9 is a cross sectional view showing a state where a resist layer having pattern holes is formed on the first metal film;
Fig. 10 is a cross sectional view showing a state where a second metal films are formed within the pattern holes in the resist layer;
Fig. 11 is a partially-cut cross sectional view showing a process for forming a metal sheet integrally having a green sheet by using a roll press;
Fig. 12 is a cross sectional view showing a laminated structure;
Fig. 13A and 13B are cross sectional views respectively showing a state where a first metal film is formed and a state where second metal films are formed in pattern holes in a resist;
Fig. 14 is a cross sectional view showing a state where a multilayered metal film is formed on a supporting member;
Fig. 15 is a cross sectional view showing a state where a green sheet integrally having the metal film is formed by molding a ceramic green sheet on the multilayered metal film;
Fig. 16 is a cross sectional view showing a monolithic ceramic structure;
Fig. 17 is a cross sectional view showing a sintered structure;
Fig. 18 is a cross sectional view showing a monolithic capacitor;
Fig. 19 is a cross sectional view showing a state where a ceramic green sheet is formed on a second supporting member according to an eighth embodiment;
Fig. 20 is a cross sectional view showing a state where a multilayered metal film is formed;
Fig. 21 is a cross sectional view showing a process for transferring a multilayered metal film to a ceramic green sheet by the method according to the eighth embodiment; and
Fig. 22 is a cross sectional view showing a green sheet integrally having the metal film obtained in the eighth embodiment.

### DESCRIPTION OF THE PREFERRED EMBODIMENTS

Referring to the drawings, preferred embodiments of the present invention will now be described.

### First Embodiment

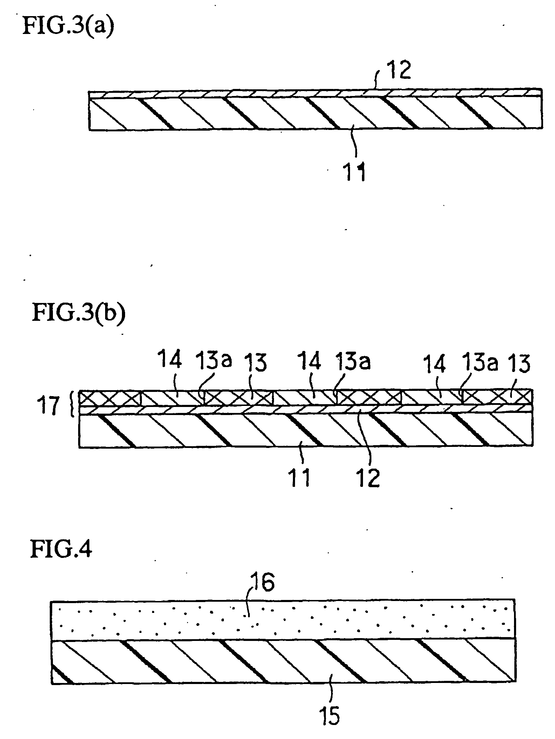

As shown in Fig. 3A, a polyethylene terephthalate film 11 serving as a first supporting member is coated with silicon resin (not shown). Then, a metal film 12, which is a first layer, is formed on the polyethylene terephthalate film 11. The metal film 12, which is the first layer, consists of an Ag layer having a thickness of 0.1 µm and formed by an evaporation method on the overall surface of film 11.

Then, a resist layer is formed on the first metal layer 12 by applying a resist to have a thickness of 0.8µm. The main components of the resist are quinone containing BaTiO₃ powder by 10 vol%, and diazide formalin resin.

Then, an exposing process and a developing process are performed so that a resist layer 13 having pattern holes 13a formed therein as shown in Fig. 3B is obtained.

Next, second metal films 14 are formed on the first metal film 12 in the regions within the pattern holes 13a formed in the resist layer 13. The second metal films 14 are formed by applying Pd to have a thickness of 0.8 µm by electroplating. The second metal film 14 forms internal electrodes to be described later.

On the other hand, a polyethylene terephthalate film 15 shown in Fig. 4 is prepared as a second supporting member. Then, ceramic slurry whose main component is BaTiO₃ is formed into a sheet on the polyethylene terephthalate film 15 to have a thickness of 6 µm so that a ceramic green sheet 16 is obtained.

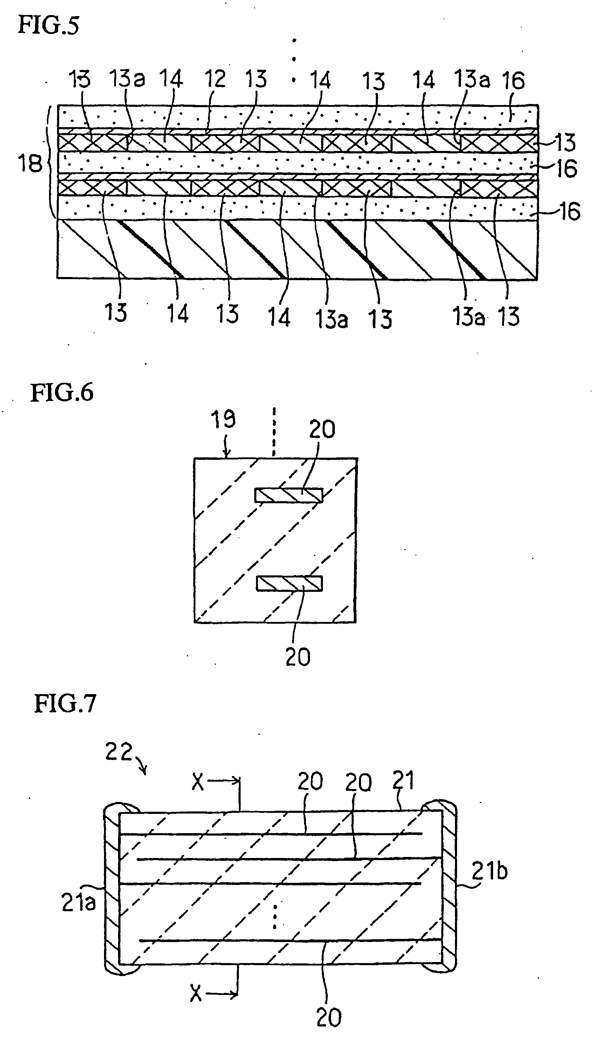

Then, a laminated member having metal layers and resist layers 17 shown in Fig. 3B and the ceramic green sheets 16 are alternately laminated so that a monolithic structure is obtained. The monolithic structure is obtained by stacking a laminated member having metal layers and resist layers 17 supported by the polyethylene terephthalate film 11 serving as the first supporting member, on the ceramic green sheet 16 so that the upper side, i.e. on which the second metal layer 14 is coated, of the monolithic structure 17 is contacted with the ceramic green sheet 16; and then pressing the monolithic structure, at about 80°C; and then stripping the polyethylene terephthalate film 11 serving as the first supporting member. Then, a similar heat pressing is performed so that the ceramic green sheets 16 and a laminated member having metal layers and resist layers 17 are sequentially laminated. Thus, a laminated member 18 shown in Fig. 5 can be obtained.

The laminated member 18 is cut in the direction of the thickness thereof to obtain predetermined monolithic chips for monolithic capacitors. Then, obtained monolithic chips are fired at 1300°C in air. As a result, a sintered member 19 shown in Fig. 6 can be obtained. In the sintered member 19, internal electrodes 20, each of which is formed by the second metal film 14, are overlapped with one another. Note that the first metal film 12 is heated in the firing process so that it is changed into an insulating material. In the resist layer, resist resin has disappeared during the firing process. On the other hand, ceramic powder contained in the resist layer and ceramics moved from the peripheral region of the resist layer form a dense sintered structure similarly to the residual sintered portions. As a result, the internal electrodes 20 are surrounded by dense ceramics, as shown in Fig. 6.

On the outer surface of the sintered structure obtained as described above, external electrodes 21a and 21b as shown in Fig. 7 are applied. Thus, a monolithic capacitor 22 is obtained. Note that Fig. 6 shows a cross section taken along line X-X of the sintered structure shown in Fig. 7.

The structure of obtained monolithic capacitor 22 is observed by cutting in the direction X-X shown in Fig. 7. As a result, stepped portions between the portions, in which the internal electrodes overlapped one another, and the portions, in which the internal electrodes did not overlap, were decreased as compared with the conventional monolithic capacitor.

The electrical characteristics of the monolithic capacitor were measured. As a result, designed characteristics were obtained. In the observation, no delamination took place in the sintered structure.

The characteristics of a monolithic capacitor manufactured by a conventional method were also measured. As a result of this, delamination was observed in the vicinity of the outlet portions for the external electrodes, that is, in the vicinity of the end surfaces of the sintered structure on which the external electrodes were formed. The percentage of these monolithic capacitors which suffered delamination was about 25 %.

The region of the monolithic capacitor according to this embodiment, in which the resist layer was formed, was observed upon cutting the sintered structure. It was seen that resist components had disappeared and the BaTiO₃ components remained. Moreover, the portion was in the sintered state similar to the other ceramic portions. Therefore, it can be considered that surrounding ceramics were moved to this portion and, therefore, a dense sintered structure was formed.

Moreover, the first metal film 12 disappeared after the firing process. Therefore, even if the first metal film is formed as described above, a problem of, for example, a short circuit, does not take place in an obtained monolithic capacitor.

### Second Embodiment

A multilayered ceramic substrate was manufactured by a method similar to that according to the first embodiment except a Cu film being used in place of the Ag film to serve as the first metal film, a Ni film being used in place of the Pd film to serve as the second metal film, resist resin containing Al₂O₃ powder by 10 vol% and glass powder by 5 vol% being used, and firing was performed at 1200°C in a reducing atmosphere.

In the obtained multilayered ceramic substrate, forming of the stepped portion between the portion, in which the internal electrodes overlapped one another, and the portion, in which the internal electrodes did not overlap, was prevented.

The characteristics of the obtained multilayered ceramic substrate were measured. As a result, designed characteristics were attained. The obtained multilayered ceramic substrate was cut in the direction of its thickness. As a result, no defect due to the delamination was observed.

The region in which the resist was formed was in substantially the same sintered state as that of the other ceramic portions. That is, it can be considered that resist components were evaporated, contained glass components were dissolved, alumina components retained and surrounding ceramics were moved when heated so that the state of sintering was realized.

The copper components forming the first metal film substantially disappeared and, thus, defects in terms of insulation and defects such as generation of voids did not take place.

### Third Embodiment

A monolithic capacitor was manufactured by a method similar to the embodiment 1 except that use was made of a resist to which inorganic powder, such as ceramic powder and glass powder serving as the resist, was not added.

The stepped portion between the portion, in which the internal electrodes overlapped one another, and the portion, in which the internal electrodes did not overlap, could not be reduced satisfactorily. However, a consideration can be performed that the pressure applied uniformly in the pressing process after the laminating step results in satisfactory prevention of generation of delamination as compared with a monolithic capacitor obtained by the conventional method.

Although the first to third embodiments were structured such that the first metal film and the second metal film were formed by different metals, the same metal may be used to form the first metal film and the second metal film.

### Fourth Embodiment

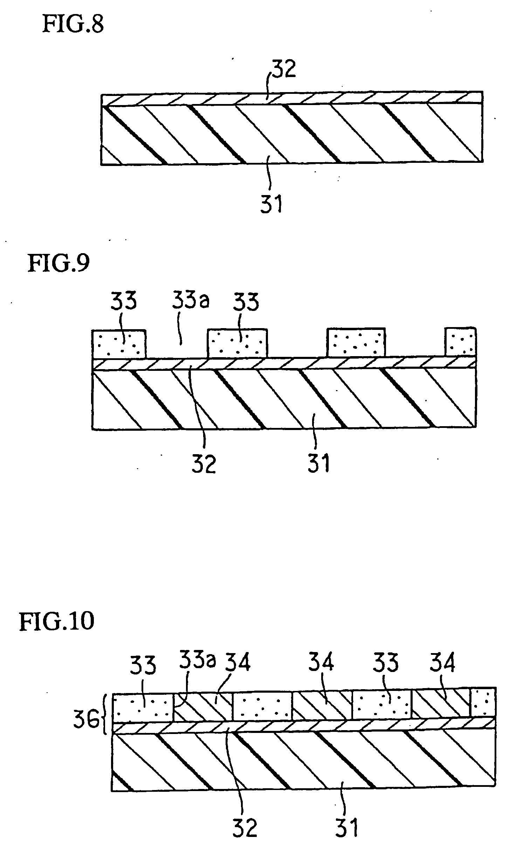

As shown in Fig. 8, a first supporting member having a PET film 31 coated with a silicon release agent (not shown) was prepared. On the silicon release agent layer, there was formed a first metal film 32. The first metal film 32 was obtained by forming a Cu film having a thickness of 0.1 µm on the overall surface by an evaporating method.

Then, a resist layer having a thickness of 0.8 µm was applied to the surface of the first metal film 32, the resist layer having a structure such that BaTiO₃ powder was contained in resist resin by 50 vol%. Then, an exposing process and a developing process were performed so that pattern holes were formed in the resist layer. As a result, a resist layer 33 having pattern holes 33a therein as shown in Fig. 9 was formed.

Then, a second metal film 34 (see Fig. 10) was formed in each pattern hole 33a. The second metal films 34 were obtained by forming Ni films each having a thickness of 0.8 µm by electroplating.

On the other hand, a PET film having a thickness of 50 µm was prepared as the second supporting member, followed by forming ceramic slurry, the main component of which was BaTiO₃ powder, in the form of a sheet on the PET film. As a result, a ceramic green sheet was produced.

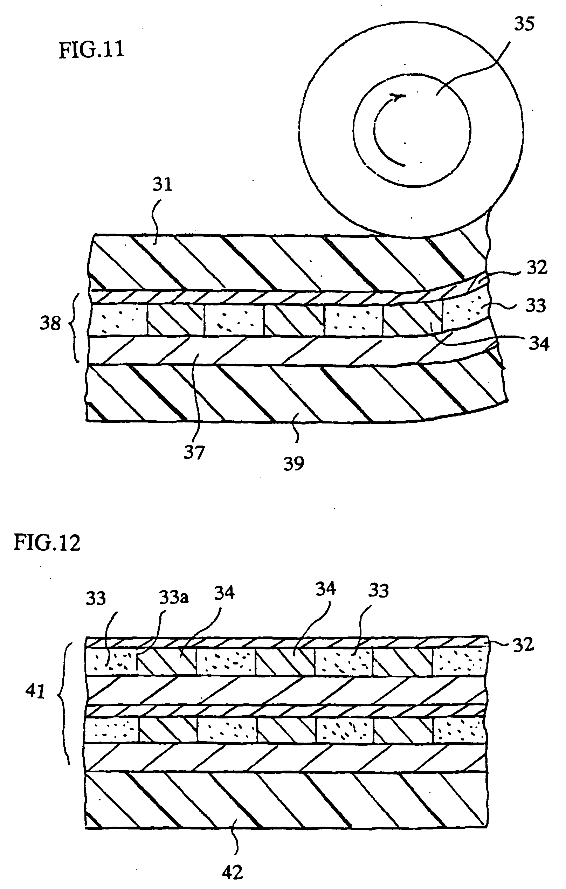

Then, a roll-type press 35 was used on the ceramic green sheet as shown in Fig. 11 so that metal-layer and resist-layer laminated member 36 (see Fig. 10) was, as the second supporting member, transferred to the ceramic green sheet 37 supported on the PET film 39. Then the PET film 39 was stripped. As a result, a green sheet 38 having the metal film was formed. Then, PET film 42 was prepared as a third supporting member. And the green sheets 38 each having the metal film were stacked on the third supporting member 42 while their relative positions being controlled accurately. Whenever one green sheet 38 having the metal film was stacked, heat pressing was performed. After the heat pressing process had been performed, the PET film 31 serving as the first supporting member was stripped so that a monolithic structure was obtained, the obtained monolithic structure being shown in Fig. 12.

Then, the laminated member 41 obtained as described above was cut in the direction of its thickness so that chips, each of which was formed into a monolithic structure, were obtained to serve as individual monolithic capacitors. Then, the monolithic chips were fired so that sintered structures were obtained, and then external electrodes were formed similarly to the first embodiment. As a result, monolithic capacitors were produced.

### Fifth Embodiment

A monolithic capacitor was manufactured similarly to the fourth embodiment except that resist containing no inorganic powder was used.

### Evaluations of the Fourth and Fifth Embodiments

In the manufacturing process according to the fourth embodiment, the monolithic structure chip was cut to observe the internal portion thereof prior to performing the firing process. It was seen that generation of a stepped portion between the portion in which the second metal films forming the internal electrodes overlapped one another and other portions could substantially be prevented.

Sintered structures in the obtained monolithic capacitor was cut in parallel to the end surface on which the external electrodes was formed so that the internal structure was observed. It was seen that generation of a stepped portion between the portion, in which the internal electrodes overlapped one another, and the portion, in which the internal electrodes did not overlap, was substantially prevented. That is, the structure, in which ceramic powder was contained in the resist layer, prevented easy generation of the stepped portion at the time of performing the firing process.

In the portion, in which the resist layer was formed, resin forming the resist disappeared and the contained ceramic powder was retained. Moreover, the portion was in a state of sintering substantially the same as that of the other ceramic portions. Therefore, it can be considered that the ceramic powder retained and the surrounding ceramics moved at the time of performing the firing process so that a state of sintering, which was the same as that of the surrounding portion, was realized.

Moreover, probably due to the thickness of the first metal film, to which the resist was applied, of 0.1 µm or thinner, the first metal film was formed into an insulating structure due to the firing process. Therefore, it can be understood that monolithic capacitors can stably be supplied, which do not easily encounter defects, such as short circuits, defective insulation, generation of voids and delamination.

Also in the fifth embodiment, the monolithic chip in a state prior to obtaining the sintered structure was cut in the direction of its thickness to observe the stepped portion between the portion, in which the second metal films, forming the internal electrodes, overlapped one another, and the other portions. It was seen that, although the stepped portion was not significantly reduced as compared with the monolithic chip obtained in the fourth embodiment, the stepped portion could be reduced satisfactorily as compared with the monolithic chip in the case of the monolithic capacitor obtained by the conventional method.

The internal structure of the obtained sintered structure was analyzed similarly to the evaluation method employed in the fourth embodiment. As a result, the first metal film portion was seen to have been formed into an insulating structure due to the firing process. Moreover, the obtained monolithic capacitor was free from defects, such as short circuits, defective insulation, generation of voids and delamination.

In the manufacturing methods according to the fourth and fifth embodiments, only the ceramic green sheet was in contact with the supporting film. Therefore, the release agent layer of the film is required to enable only the ceramic green sheet to be stripped easily. Thus, an appropriate release agent on the market can be employed and, therefore, the release agent layer can easily be designed.

The force required to strip off the supporting film when the layers were stacked in the case where an appropriate release agent layer was employed was measured. Results were shown in Table 1.

**Table 1**

| | Force required to strip a supporting film |
|---|---|
| Conventional Structure | 20 g/cm² |
| Embodiments 4 and 5 | 3 g cm² |

As can be understood from Table 1, the supporting film could be stripped from the ceramic green sheets according to the fourth and fifth embodiments with a force of one-third that required with the conventional structure. Therefore, a problem of defective transference can satisfactorily be prevented and, thus, generation of delamination can significantly be prevented.

Although the following embodiments are examples in each of which the present invention is adapted to manufacture a monolithic capacitor, the processes including the process for obtaining the monolithic ceramic structure, which has not been fired, employ a mother multilayered metal film and a mother ceramic green sheet.

### Sixth Embodiment

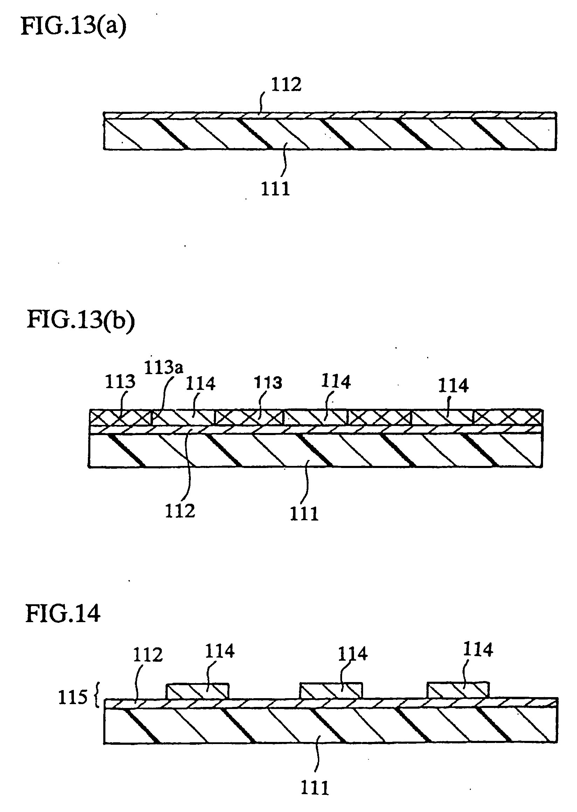

As shown in Fig. 13A, a polyethylene terephthalate (PET) film 111 was prepared as the first supporting member. The top surface of the PET film 111 was coated with silicon resin (not shown). A first metal film 112 was formed on the PET film 111. The first metal film 112 could be obtained by forming an Ag film having a thickness of 70 nm on the entire surface of the PET film 111 by an evaporation method. Then, a resist layer having a thickness of 1 µm is applied to the top surface of the first metal film 112, and then exposing and developing processes are performed. As a result, a resist layer 113 patterned as shown in Fig. 13B is formed. Next, a second metal film 114 is formed in each of pattern holes 113a of the resist layer 113 by a thin film forming method. In this embodiment, the second metal film 114 is formed to have a thickness of 0.5 µm by electroplating Pd.

Then, the resist layer 113 is stripped by resist stripping liquid or the like. Thus, a multilayered metal film 115 shown in Fig. 14 is obtained, the multilayered metal film 115 including the second metal film 114 formed partially on the first metal film 112 therein. Therefore, the multilayered metal film 115 is in contact with the PET film 111 on only the lower surface of the first metal film 112 thereof. As a result, the releasing facility of the PET film 111 is required with respect to the first metal film 112. Therefore, the releasing facility on the top surface of the PET film 111 can easily be designed.

The second metal film 114 corresponds to the portion to be finally used as the internal electrode, while the first metal film 112 is formed into an insulating structure due to a process to be described later.

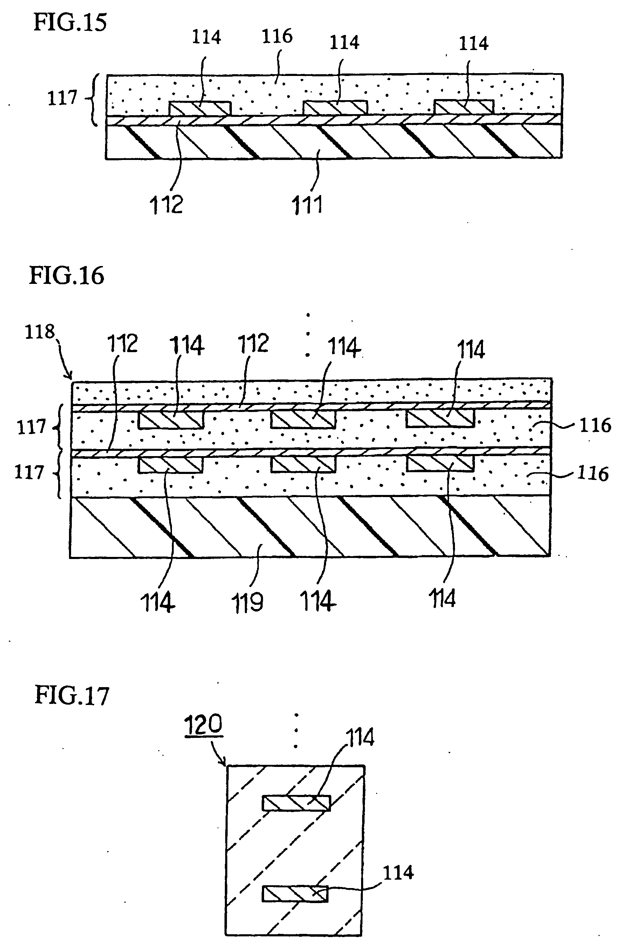

Then, a ceramic green sheet is formed on the multilayered metal film 115 on the PET film 111. In this embodiment, ceramic slurry is formed into a sheet having a thickness of 8 µm by a microgravure method so that a ceramic green sheet 116 is formed (see Fig. 15).

As shown in Fig. 15, since the ceramic green sheet 116 is formed in situ, a green sheet 117 integrally having the metal film is prepared while being supported on the PET film 111.

Then, the green sheets 117 integrally having the metal film are sequentially stacked so that a laminated structure 118 shown in Fig. 16 is obtained. Although Fig. 16 shows several layers below the laminated structure 118, a plurality of the green sheets 117 integrally having the metal film are further stacked in the upward direction. Reference numeral 119 represents a supporting film for use in the laminating process.

The mother laminated structure 118 is cut into a direction of its thickness to be formed into individual monolithic ceramic structures for respective monolithic capacitors. Thus, monolithic ceramic structures for respective monolithic capacitors are obtained.

The monolithic ceramic structures are heated at 1200°C for 4 hours in the atmosphere so that the monolithic ceramic structures are fired. In the firing process, the first metal film 112 is formed into an insulating structure as well as non-fired ceramics are fired. That is, metal components forming the first metal film 112 are formed into oxide ions which are diffused into surrounding ceramics so as to be formed into insulating substances. Therefore, only the internal electrodes formed by the second metal films 114 remain in a sintered structure 120, the cross sectional shape of which is shown in Fig. 17. Although Fig. 17 shows only two second metal films 114, a multiplicity of second metal films serving as the internal electrodes overlap one another in the upward direction with ceramic layers being interposed.

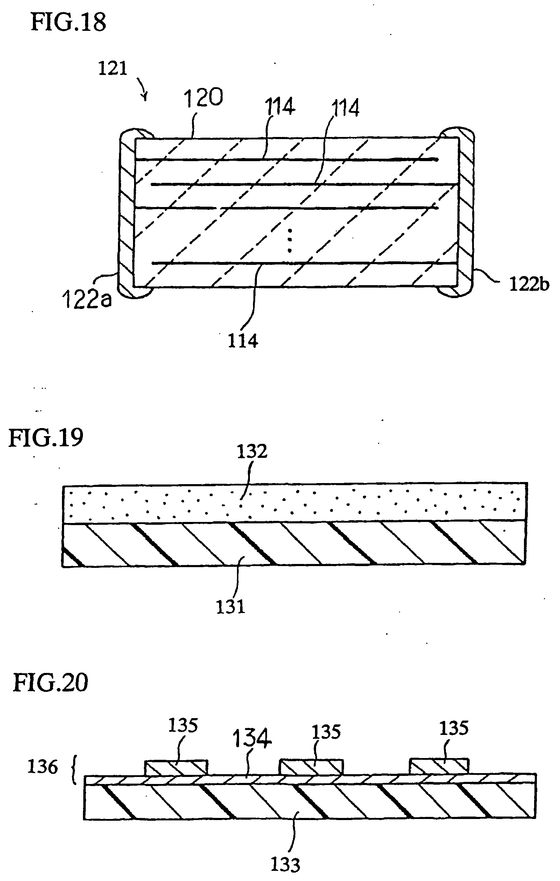

By forming a pair of external electrodes on the two end surfaces of the sintered structure 120, a monolithic capacitor 121 shown in Fig. 18 is obtained. In the monolithic capacitor 121, a plurality of the internal electrodes formed by the second metal films 114 overlap one another in the sintered structure 120 with a monolithic ceramic structure being interposed. Note that reference numerals 122a and 122b represent external electrodes. The external electrodes 122a and 122b can be formed by an appropriate method, such as applying, firing or plating of conductive paste.

The generation of a stepped portion in the thus-obtained monolithic capacitor between a portion, in which the internal electrodes overlapped one another, and a portion, in which the internal electrodes did not overlap was examined. As a result, the stepped portion can be reduced by a quantity corresponding to a result obtainable from a calculation (the thickness of the first metal film) x (the number of stacked first metal films).

Twenty monolithic capacitors were prepared, and each of the monolithic capacitors was cut in such a manner that its cross section was exposed to the outside as shown in Fig. 18 to observe whether or not delamination has taken place. No delamination was observed. Similarly, twenty monolithic capacitors were cut in such a manner that the cross section of each of the monolithic capacitors perpendicular to the cross section shown in Fig. 18 was exposed to the outside to observe the cross section. No delamination was observed, similarly to the previous case.

To make a comparison, it was observed whether or not delamination had taken place in each of corresponding monolithic capacitors obtained by the first method described in the related background art. When the cross sections in the same direction as the cross sections shown in Fig. 18 were observed, delamination was observed in five monolithic capacitors among twenty monolithic capacitors.

Since the fusing point of the first metal film in this embodiment of the invention was about 960°C, which was a sufficiently low level with respect to the sintering temperature of 1200°C, the first metal film was formed into the insulating structure. Therefore, the monolithic capacitors according to this embodiment were free from generation of short circuits.

### Seventh Embodiment

Monolithic capacitors were manufactured similarly to the sixth embodiment except that the first metal film was made of Cu and the second metal film was made of Ni. The ceramic slurry was composed of BaTiO₃ type ceramics which did not contain Cu. The firing process was performed in such a manner that, during the initial period of the firing process, the partial pressure for oxygen was set to a level at which the plated Ni film could not be oxidized but the evaporated Cu film could be oxidized, this initial period having a duration which is half of the period in which the temperature for firing was maintained at the highest level. Specifically, the partial pressure for oxygen was set to 10⁻⁴ Pa. After the initial period of the firing process had been performed at the partial pressure for oxygen of 10⁻⁴ Pa, the firing process was performed in a reducing atmosphere. The other conditions were the same as those employed in the sixth embodiment so that the monolithic capacitors were manufactured.

The sintered structure of each of the monolithic capacitors obtained in the seventh embodiment was analyzed. As a result, uniform distribution of Cu in ceramics was confirmed. That is, diffusion of Cu composing the first metal film in the ceramics was confirmed.

The electrical characteristics of the obtained monolithic capacitors were measured. As a result, an effect similar to that obtainable in the case where Cu powder was added to BaTiO₃ type ceramics could be obtained.

The cross section of each monolithic capacitor was observed similarly to the sixth embodiment. No generation of delamination was observed.

Although according to the seventh embodiment the partial pressure for oxygen in the initial period of the firing process was controlled to diffuse Cu composing the first metal film, an oxidation diffusing agent may be added to the first metal film or diffusion enhancer may be added to diffuse the metal components composing the first metal film into the ceramics.

### Eighth Embodiment

As shown in Fig. 19, a PET film 131 serving as the second supporting member is prepared. The top surface of the PET film 131 is coated with silicon resin (not shown).

By forming ceramic slurry on the PET film 131 by a doctor blade method followed by being dried, a ceramic green sheet 132 having a thickness of 8 µm is formed.

On the other hand, a PET film 133 shown in Fig. 20 is prepared as the first supporting member. The top surface of the PET film 133 is coated with silicon resin (not shown).

Similarly to the sixth embodiment, a first metal film 134 and a second metal film 135 are formed on the PET film 133. In this embodiment, the first metal film 134 is made of Ag and the second metal film 135 is made of Pd. Thus, a multilayered metal film 136 is formed.

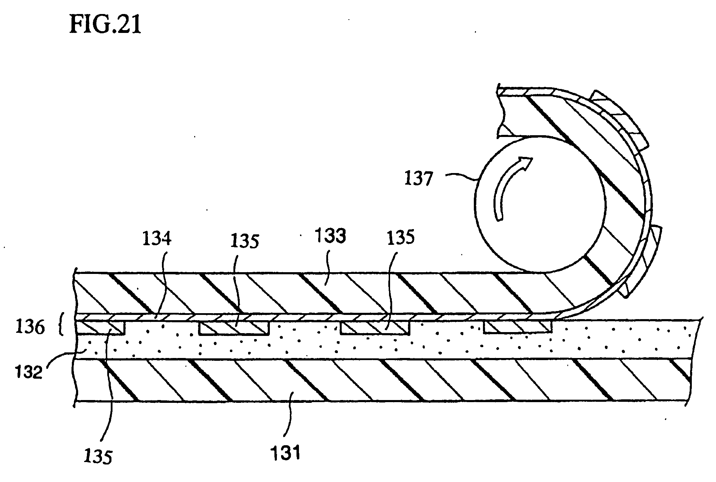

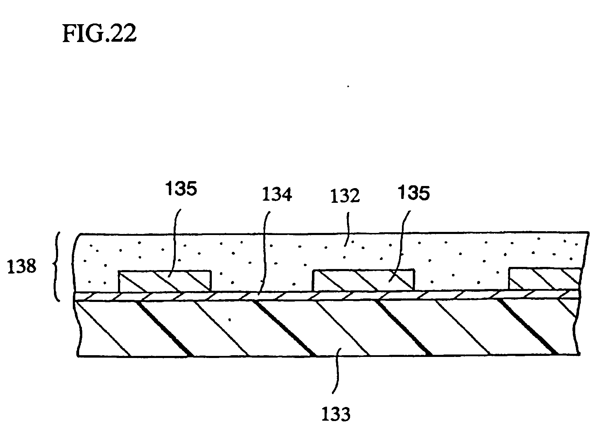

Then, a calendar roll 137 is used as shown in Fig. 21 so that the multilayered metal film 136 is transferred to the ceramic green sheet 132. Then, the PET film 131 is stripped so that a green sheet 138 integrally having the metal film as shown in Fig. 22 is obtained.

By stacking the thus-obtained green sheets 138 each integrally having the metal film, a laminated structure can be obtained. That is, by stripping and stacking the PET films 133 while transferring the green sheets 138 each integrally having the metal film, a monolithic ceramic structure similar to that obtained in the sixth embodiment can be obtained.

The thus-obtained monolithic ceramic structures were used to manufacture monolithic capacitors similarly to the sixth embodiment.

An observation was performed as to whether or not the obtained monolithic capacitors according to the eighth embodiment encountered delamination. No generation of delamination was observed.

Since the method of manufacturing monolithic capacitor employing the conventional transferring method involves the ceramics and the metal film being in contact with the supporting film, the supporting film must be capable of being easily stripped from both the ceramics and the metal film. However, since the eighth embodiment has the structure in which only the first metal film 134 is in contact with the PET film 133, the PET film 133 is required to be easily stripped from only the first metal film 134.

In the sixth to eighth embodiments, the first metal films 112 and 134 are partially diffused in the firing process and, therefore, they are formed into insulating structures. As a result, it can be understood that a complicated process is not required in which the first metal film portion, which is not located below the second metal film, is stripped by etching or the like.

Although the sixth to eighth embodiments have the arrangement in which the first metal film is made of Ag or Cu and the second metal film is made of Pd or Ni, other metals may be employed if the effect of the present invention can be attained.

## Claims

1. A method of manufacturing a monolithic ceramic electronic device, comprising the steps of:
forming a first metal film (12/112) on a first supporting member (11/111) by a thin film forming method;
forming a multilayered metal film (17/115) by forming a second metal film (14/114) on said first metal film (12, 112) by a thin film forming method;
forming a monolithic ceramic structure (18/118) incorporating said multilayered metal film and at least one ceramic green sheet (16/132);
**characterised in that**:
there are portions of said first metal film (12/112) that are not overlain by said second metal film (14/114);
said first metal film (12/112) has a first thickness, and said second metal film (14/114) has a second thickness, greater than said first thickness, the first and second thicknesses being selected such that common firing conditions can form a portion of said first metal film (12/112) which is not overlain by said second metal film (14/114) in said monolithic ceramic structure into an insulating structure but not so form the second metal film (14/114); and
the method further comprising the step of:
forming said portion of said first metal film (12/112) which is not overlain by said second metal film (14/114) in said monolithic ceramic structure into an insulating material by firing said monolithic ceramic structure.

2. A method of manufacturing a monolithic ceramic electronic device according to claim 1, wherein the thickness of said first metal film (12/112) is 100 nm or thinner and the thickness of said second metal film (14/114) is between 300 nm and 1000 nm, boundaries included.

3. A method of manufacturing a monolithic ceramic electronic device according to claim 1 or 2, wherein said step of converting a portion of said first metal film (12/112) into the insulating structure consists of firing said monolithic ceramic structure (18/118) under a partial pressure for oxygen at which said portion of the first metal film (12/112) is oxidised but said second metal film (14/114) is not oxidised.

4. A method of manufacturing a monolithic ceramic electronic device according to claim 1, 2, 3 or 4, wherein said step of forming said multilayered metal film (17/115) has the steps of forming, on said first metal film (12/112), a resist layer (13/113) having pattern holes (13a/113a) therein; and forming, within each said pattern hole (13a/113a) in said resist layer, a second metal film (14/114) thicker than said first metal film (12/112) by a thin film forming method.

5. A method of manufacturing a monolithic ceramic electronic device according to claim 4 wherein, during firing, the resist layer is converted to a sintered state substantially the same as that of the other ceramic portions.

6. A method of manufacturing a monolithic ceramic electronic device according to claim 4, and comprising the step of stripping away the resist layer (13/113).

7. A method of manufacturing a monolithic ceramic electronic device according to claim 4 or 5, wherein said resist layer (13) contains a resist resin and inorganic components.

8. A method of manufacturing a monolithic ceramic electronic device according to claim 7, wherein said ceramics are used as said inorganic components.

9. A method of manufacturing a monolithic ceramic electronic device according to claim 7, wherein glass is used as said inorganic components.

10. A method of manufacturing a monolithic ceramic electronic device according to any previous claim, wherein said step of forming said monolithic ceramic structure (18/118) has the steps of: forming a metal film-integrated green sheet (117) by forming a ceramic green sheet (116) on said multilayered metal film (115), and stacking a plurality of said metal film-integrated green sheets (117).

11. A method of manufacturing a monolithic ceramic electronic device according to any one of claims 1 to 9, wherein said step of forming said monolithic ceramic structure has the steps of:
forming a ceramic green sheet (16/132) on a second supporting member (15/131);
forming a metal film-integrated green sheet (13-16/138) by transferring to said ceramic green sheet (16/132) said multilayered metal film (17/136) supported by said first supporting member (11/133) and then removing said first supporting member (11/133); and
stacking a plurality of said metal film-integrated green sheets to form the monolithic ceramic structure.

12. A method of manufacturing a monolithic ceramic electronic device according to claim 11, wherein said multilayered metal film (136) is transferred to said ceramic green sheet by using a roll press (137).

13. A method of manufacturing a monolithic ceramic electronic device according to any one of claims 1 to 9, wherein said step of forming said monolithic ceramic structure has the steps of:
forming a ceramic green sheet (16/132) on a second supporting member (15/131);
separating said multilayered metal film (17/136) from said first supporting member (11/133);
separating said ceramic green sheet (16/132) from said second supporting member (15/131); and
alternately stacking said multilayered films (17/136) and said ceramic green sheets (16/132).

14. A method of manufacturing a monolithic ceramic electronic device according to any previous claim, wherein said first metal film (12/112) consists of Cu and said second metal film (14/114) consists of Ni.

15. A method of manufacturing a monolithic ceramic electronic device according to claim 3, wherein partial pressure of O₂ is maintained so that said second metal film is not oxidised while the first metal film remains in a initial half period of said forming step.

16. A method of manufacturing a monolithic ceramic electronic device according to claim 15, wherein said first metal film consists of Cu and said second metal film consist of Ni.

17. A method of manufacturing a monolithic ceramic electronic device according to claim 16, wherein said partial pressure of O₂ is 10⁻⁴ Pascal.

18. A method of manufacturing a monolithic ceramic electronic device according to claim 15, wherein the forming step is performed under reducing atmosphere after said initial half period of said forming step.

## Patentansprüche

1. Ein Verfahren zum Herstellen einer monolithischen, elektronischen Keramikvorrichtung, das folgende Schritte aufweist:
Bilden eines ersten Metallfilms (12/112) auf einem ersten Stützbauglied (11/111) durch ein Dünnfilmbildungsverfahren;
Bilden eines Mehrschicht-Metallfilms (17/115) durch Bilden eines zweiten Metallfilms (14/114) auf dem ersten Metallfilm (12/112) durch ein Dünnfilmbildungsverfahren;
Bilden einer monolithischen Keramikstruktur (18/118), die den Mehrschicht-Metallfilm und zumindest eine Keramikgrünschicht (16/132) einlagert;
**dadurch gekennzeichnet, dass**:
Abschnitte des ersten Metallfilms (12/112) vorliegen, die nicht durch den zweiten Metallfilm (14/114) überlagert sind;
wobei der erste Metallfilm (12/112) eine erste Dicke aufweist und der zweite Metallfilm (14/114) eine zweite Dicke aufweist, die größer ist als die erste Dicke, wobei die erste und die zweite Dicke derart ausgewählt sind, dass gemeinsame Brennbedingungen einen Abschnitt des ersten Metallfilms (12/112), der nicht durch den zweiten Metallfilm (14/114) in der monolithischen Keramikstruktur überlagert ist, in eine isolierende Struktur bilden können, aber den zweiten Metallfilm (14/114) nicht so bilden können; und
wobei das Verfahren ferner folgenden Schritt aufweist:
Bilden des Abschnitts des ersten Metallfilms (12/112), der nicht durch den zweiten Metallfilm (14/114) in der monolithischen Keramikstruktur überlagert ist, in ein isolierendes Material, durch Brennen der monolithischen Keramikstruktur.

2. Ein Verfahren zum Herstellen einer monolithischen, elektronischen Keramikvorrichtung gemäß Anspruch 1, bei der die Dicke des ersten Metallfilms (12/112) 100 nm oder dünner ist und die Dicke des zweiten Metallfilms (14/114) zwischen 300 nm und 1.000 nm ist, Grenzen eingeschlossen.

3. Ein Verfahren zum Herstellen einer monolithischen, elektronischen Keramikvorrichtung gemäß Anspruch 1 oder 2, bei der der Schritt des Umwandelns eines Abschnitts des ersten Metallfilms (12/112) in die isolierende Struktur aus dem Brennen der monolithischen Keramikstruktur (18/118) unter einem Teildruck für Sauerstoff besteht, bei dem der Abschnitt des ersten Metallfilms (12/112) oxidiert wird, aber der zweite Metallfilm (14/114) nicht oxidiert wird.

4. Ein Verfahren zum Herstellen einer monolithischen, elektronischen Keramikvorrichtung gemäß Anspruch 1, 2, 3 oder 4, bei dem der Schritt des Bildens des Mehrschicht-Metallfilms (17/115) die Schritte des Bildens, auf dem ersten Metallfilm (12/112), einer Resistschicht (13/113) mit Strukturlöchern (13a/113a) in derselben; und des Bildens, innerhalb jedes Strukturlochs (13a/113a) in der Resistschicht, eines zweiten Metallfilms (14/114) aufweist, der dicker ist als der erste Metallfilm (12/112), durch ein Dünnfilmbildungsverfahren.

5. Ein Verfahren zum Herstellen einer monolithischen, elektronischen Keramikvorrichtung gemäß Anspruch 4, bei dem während des Brennens die Resistschicht in einen gesinterten Zustand umgewandelt wird, der im Wesentlichen gleich zu dem der anderen Keramikabschnitte ist.

6. Ein Verfahren zum Herstellen einer monolithischen, elektronischen Keramikvorrichtung gemäß Anspruch 4, das den Schritt des Abstreifens der Resistschicht (13/113) aufweist.

7. Ein Verfahren zum Herstellen einer monolithischen, elektronischen Keramikvorrichtung gemäß Anspruch 4 oder 5, bei dem die Resistschicht (13) ein Resistharz und anorganische Komponenten enthält.

8. Ein Verfahren zum Herstellen einer monolithischen, elektronischen Keramikvorrichtung gemäß Anspruch 7, bei der die Keramik als die anorganischen Komponenten verwendet wird.

9. Ein Verfahren zum Herstellen einer monolithischen, elektronischen Keramikvorrichtung gemäß Anspruch 7, bei der Glas als die anorganischen Komponenten verwendet wird.

10. Ein Verfahren zum Herstellen einer monolithischen, elektronischen Keramikvorrichtung gemäß einem der vorangehenden Ansprüche, bei dem der Schritt des Bildens der monolithischen Keramikstruktur (18/118) folgende Schritte aufweist: Bilden einer Metallfilm-integrierten Grünschicht (117) durch Bilden einer Keramikgrünschicht (116) auf dem Mehrschicht-Metallfilm (115) und Stapeln einer Mehrzahl der Metallfilm-integrierten Grünschichten (117).

11. Ein Verfahren zum Herstellen einer monolithischen, elektronischen Keramikvorrichtung gemäß einem der Ansprüche 1 bis 9, bei dem der Schritt des Bildens der monolithischen Keramikstruktur folgende Schritte aufweist:
Bilden einer Keramikgrünschicht (16/132) auf einem zweiten Stützbauglied (15/131);
Bilden einer Metallfilm-integrierten Grünschicht (13-16/138) durch Übertragen des Mehrschicht-Metallfilms (17/136) auf die Keramikgrünschicht (16/132), der durch das erste Stützbauglied (11/133) gestützt wird, und dann Entfernen des Stützbauglieds (11/133); und
Stapeln einer Mehrzahl der Metallfilm-integrierten Grünschichten, um die monolithische Keramikstruktur zu bilden.

12. Ein Verfahren zum Herstellen einer monolithischen, elektronischen Keramikvorrichtung gemäß Anspruch 11, bei dem der Mehrschicht-Metallfilm (136) auf die Keramikgrünschicht unter Verwendung einer Rollenpresse (137) übertragen wird.

13. Ein Verfahren zum Herstellen einer monolithischen, elektronischen Keramikvorrichtung gemäß einem der Ansprüche 1 bis 9, bei dem der Schritt des Bildens der monolithischen Keramikstruktur folgende Schritte aufweist:
Bilden einer Keramikgrünschicht (16/132) auf einem zweiten Stützbauglied (15/131);
Trennen des Mehrschicht-Metallfilms (17/136) von dem ersten Stützbauglied (11/133);
Trennen der Keramikgrünschicht (16/132) von dem zweiten Stützbauglied (15/131); und
abwechselndes Stapeln der Mehrschicht-Filme (17/136) und der Keramikgrünschichten (16/132).

14. Ein Verfahren zum Herstellen einer monolithischen, elektronischen Keramikvorrichtung gemäß einem der vorangehenden Ansprüche, bei dem der erste Metallfilm (12/112) aus Cu besteht und der zweite Metallfilm (14/114) aus Ni besteht.

15. Ein Verfahren zum Herstellen einer monolithischen, elektronischen Keramikvorrichtung gemäß Anspruch 3, bei dem ein Teildruck von O₂ so beibehalten wird, dass der zweite Metallfilm nicht oxidiert wird, während der erste Metallfilm in einer anfänglichen halben Periode des Bildungsschrittes verbleibt.

16. Ein Verfahren zum Herstellen einer monolithischen, elektronischen Keramikvorrichtung gemäß Anspruch 15, bei dem der erste Metallfilm aus Cu besteht und der zweite Metallfilm aus Ni besteht.

17. Ein Verfahren zum Herstellen einer monolithischen, elektronischen Keramikvorrichtung gemäß Anspruch 16, bei dem der Teildruck von O₂ 10⁻⁴ Pascal ist.

18. Ein Verfahren zum Herstellen einer monolithischen, elektronischen Keramikvorrichtung gemäß Anspruch 15, bei dem der Bildungsschritt unter einer reduzierenden Atmosphäre ausgeführt wird, nach der anfänglichen halben Periode des Bildungsschrittes.

## Revendications

1. Procédé de fabrication d'un dispositif électronique monolithique en céramique, comprenant les étapes consistant à :
former un premier film en métal (12/112) sur un premier élément de support (11/111) par un procédé de formation de films minces ;
former un film en métal multicouches (17/115) en formant un second film en métal (14/114) sur ledit premier film en métal (12/112) par un procédé de formation de films minces ;
former une structure céramique monolithique (18/118) qui incorpore ledit film en métal multicouches et au moins une feuille céramique à l'état cru (16/132) ;
**caractérisé en ce que** :
il existe des portions dudit premier film en métal (12/112) qui ne sont pas recouvertes par ledit second film en métal (14/114) ;
ledit premier film en métal (12/112) a une première épaisseur, et ledit second film en métal (14/114) a une seconde épaisseur, supérieure à ladite première épaisseur, la première et la seconde épaisseur étant choisies de telle façon que des conditions de cuisson communes peuvent former une portion dudit premier film en métal (12/112) qui n'est pas recouverte par ledit second film en métal (14/114) dans ladite structure céramique monolithique en une structure d'isolation mais sans former ainsi le second film en métal (14/114) ; et
le procédé comprenant en outre les étapes consistant à :
former ladite portion dudit premier film en métal (12/112) qui n'est pas recouverte par ledit second film en métal (14/114) dans ladite structure céramique monolithique en un matériau isolant par cuisson de ladite structure céramique monolithique.

2. Procédé de fabrication d'un dispositif électronique monolithique en céramique selon la revendication 1, dans lequel l'épaisseur dudit premier film en métal (12/112) est de 100 nm ou moins, et l'épaisseur dudit second film en métal (14/114) est entre 300 nm et 1000 nm, frontières incluses.

3. Procédé de fabrication d'un dispositif électronique monolithique en céramique selon les revendications 1 ou 2, dans lequel ladite étape de conversion d'une portion dudit premier film en métal (12/112) pour donner la structure isolante consiste à faire cuire ladite structure monolithique en céramique (18/118) sous une pression partielle d'oxygène à laquelle ladite portion du premier film en métal (12/112) est oxydée mais ledit second film en métal (14/114) n'est pas oxydé.

4. Procédé de fabrication d'un dispositif électronique monolithique en céramique selon les revendications 1, 2, 3 ou 4, dans lequel ladite étape de formation dudit film en métal multicouches (17/115) comprend les étapes consistant à former, sur ledit premier film en métal (12/112), une couche de produit résistant (13/113) comprenant des trous en motif (13a/113a) 'à l'intérieur, et à former, à l'intérieur de chaque trou en motif (13a/113a) dans ladite couche de produit résistant, un second film en métal (14/114) plus épais que ledit premier film en métal (12/112) par un procédé de formation de films minces.

5. Procédé de fabrication d'un dispositif électronique monolithique en céramique selon la revendication 4, dans lequel, pendant la cuisson, la couche de produit résistant est convertie à un état fritté sensiblement le même que celui des autres portions en céramique.

6. Procédé de fabrication d'un dispositif électronique monolithique en céramique selon la revendication 4, comprenant l'étape consistant à éloigner la couche de produit résistant (13/113) par pelage.

7. Procédé de fabrication d'un dispositif électronique monolithique en céramique selon la revendication 4 ou 5, dans lequel ladite couche de produit résistant (13) contient une résine résistante et des composants inorganiques.

8. Procédé de fabrication d'un dispositif électronique monolithique en céramique selon la revendication 7, dans lequel lesdites céramiques sont utilisées à titre de composants inorganiques.

9. Procédé de fabrication d'un dispositif électronique monolithique en céramique selon la revendication 7, dans lequel du verre est utilisé à titre de composants inorganiques.

10. Procédé de fabrication d'un dispositif électronique monolithique en céramique selon l'une quelconque des revendications précédentes, dans lequel ladite étape consistant à former ladite structure céramique monolithique (18/118) comprend les étapes consistant à : former une feuille crue (117) à film en métal intégré en formant une feuille crue en céramique (116) sur ledit film en métal multicouches (115), et à empiler une pluralité desdites feuilles crues (117) à film en métal intégré.

11. Procédé de fabrication d'un dispositif électronique monolithique en céramique selon l'une quelconque des revendications 1 à 9, dans lequel ladite étape consistant à former ladite structure céramique monolithique comprend les étapes consistant à :
former une feuille crue en céramique (16/132) sur un second élément de support (15/131) ;
former une feuille crue (13-16/138) à film en métal intégré, en transférant sur ladite feuille crue en céramique (16/132) ledit film en métal multicouches (17/136) supporté par ledit premier élément de support (11/133) puis en enlevant ledit premier élément de support (11/133) ; et
empiler une pluralité desdites feuilles crues à film en métal intégré en un film pour former la structure céramique monolithique.

12. Procédé de fabrication d'un dispositif électronique monolithique en céramique selon la revendication 11, dans lequel ledit film en métal multicouches (136) est transféré à ladite feuille crue en céramique en utilisant une presse à rouleau (137).

13. Procédé de fabrication d'un dispositif électronique monolithique en céramique selon l'une quelconque des revendications 1 à 9, dans lequel ladite étape consistant à former ladite structure céramique monolithique comprend les étapes consistant à :
former une feuille crue en céramique (16/132) sur un second élément de support (15/131) ;
séparer ledit film en métal multicouches (17/136) depuis ledit premier élément de support (11/133) ;
séparer ladite feuille crue en céramique (16/132) depuis ledit second élément de support (15/131) ; et
empiler alternativement lesdits films multicouches (17/136) et lesdites feuilles crues en céramique (16/132).

14. Procédé de fabrication d'un dispositif électronique monolithique en céramique selon l'une quelconque des revendications précédentes, dans lequel ledit premier film en métal (12/112) est constitué en Cu et ledit second film en métal (14/114) est constitué en Ni.

15. Procédé de fabrication d'un dispositif électronique monolithique en céramique selon la revendication 3, dans lequel la pression partielle de O₂ est maintenue de telle façon que ledit second film en métal n'est pas oxydé alors que le premier film en métal reste dans une demi-période initiale de ladite étape de formation.

16. Procédé de fabrication d'un dispositif électronique monolithique en céramique selon la revendication 15, dans lequel ledit premier film en métal est constitué en Cu et ledit second film en métal est constitué en Ni.

17. Procédé de fabrication d'un dispositif électronique monolithique en céramique selon la revendication 16, dans lequel ladite pression partielle de O₂ est 10⁻⁴ Pa.

18. Procédé de fabrication d'un dispositif électronique monolithique en céramique selon la revendication 15, dans lequel l'étape de formation est exécutée sous atmosphère réductrice après ladite demi-période initiale de ladite étape de formation.
